# DEMANDE DE BREVET EUROPEEN

(11) **EP 2 782 118 A1**
(43) Date de publication de la demande: **24.09.2014**
(21) Numéro de dépôt: 14160728.3
(22) Date de dépôt: 19.03.2014
(51) Int. Cl.: H01L 21/02

(54) **Procédé de formation d'une couche de silicium contraint**

(30) Priorité: 20.03.2013 FR 1352497
(71) Demandeur: STMicroelectronics (Crolles 2) SAS, 38920 Crolles (FR); COMMISSARIAT A L'ENERGIE ATOMIQUE ET AUX ENERGIES ALTERNATIVES, 75015 Paris (FR)
(72) Inventeur: Halimaoui, Aomar, 38660 La Terrasse (FR); Hartmann, Jean-Michel, 38240 Meylan (FR); Maitrejean, Sylvain, 38000 Grenoble (FR)
(74) Mandataire: Thibon, Laurent

(57) **Abrégé**

L'invention concerne un procédé comprenant : formation d'une couche contrainte de silicium germanium (208) par croissance épitaxiale sur une couche de silicium (206) disposée sur un substrat (202) ; implantation des atomes pour amorphiser la couche de silicium et une partie inférieure (208A) de la couche de silicium germanium sans amorphiser une partie superficielle (208B) de la couche de silicium germanium ; et recuit pour au moins partiellement relaxer la couche de silicium germanium et pour recristalliser la partie inférieure (208A) de la couche de silicium germanium et la couche de silicium (206), d'où il résulte que la couche de silicium devient une couche de silicium contraint.

## Description

### Domaine

La présente description concerne le domaine des structures de type silicium sur isolant (SOI), et en particulier un procédé de formation d'une couche de silicium contraint.

### Arrière plan

Dans certaines applications, par exemple pour la formation de transistors à haute performance, il peut être avantageux d'utiliser une couche de silicium contraint ou une couche de silicium germanium. En particulier, les couches de silicium qui sont sous tension et/ou sous compression induisent une augmentation de la vitesse des porteurs de charge, augmentant ainsi les performances de dispositifs à transistors formés dans de telles couches.

Les techniques existantes pour former une couche de silicium contraint impliquent généralement la formation d'une couche de silicium par croissance épitaxiale au-dessus d'une couche de silicium germanium (SiGe) relaxée. Ainsi, les atomes de silicium sont étirés au-delà de leur distance interatomique normale par la couche de base de SiGe, d'où il résulte une couche de silicium contraint.

Un problème avec de telles techniques existantes est qu'il tend à apparaître une relativement forte densité de défauts dans la couche de SiGe relaxée, ces défauts étant transférés dans la couche épitaxiale de silicium.

Il existe donc un besoin dans la technique pour un procédé amélioré de formation d'une couche de silicium contraint.

### Résumé

Un objet de modes de réalisation de la présente description est de traiter au moins partiellement un ou plusieurs des problèmes de l'art antérieur.

Selon un aspect, il est prévu un procédé comprenant : formation d'une couche contrainte de silicium germanium par croissance épitaxiale sur une couche de silicium disposée sur un substrat ; implantation des atomes pour amorphiser la couche de silicium et une partie inférieure de la couche de silicium germanium sans amorphiser une partie superficielle de la couche de silicium germanium ; et recuit pour au moins partiellement relaxer la couche de silicium germanium et pour recristalliser la partie inférieure de la couche de silicium germanium et la couche de silicium, d'où il résulte que la couche de silicium devient une couche de silicium contraint.

Selon un mode de réalisation, la couche de silicium est formée sur une couche amorphe disposée sur le substrat, et la couche amorphe est par exemple une couche d'oxyde formée sur le substrat.

Selon un mode de réalisation, pendant l'étape d'implantation, des atomes sont implantés à profondeur maximum tombant dans la couche amorphe ou dans le substrat.

Selon un mode de réalisation, l'implantation des atomes pendant l'étape d'implantation est localisée par un masque.

Selon un mode de réalisation, la couche de silicium germanium a une épaisseur comprise entre 20 et 200 nm.

Selon un mode de réalisation, la couche de silicium germanium a une épaisseur inférieure à l'épaisseur critique, épaisseur sous laquelle le SiGe croît sans défaut avec le paramètre de maille de la couche de silicium sous-jacente.

Selon un mode de réalisation, la couche de silicium germanium a une concentration en germanium comprise entre 10 et 50 %.

Selon un mode de réalisation, la partie superficielle a une épaisseur d'au moins 1 nm.

Selon un mode de réalisation, le recuit est réalisé à une température comprise entre 500°C et 1100°C, et le recuit comprend par exemple un recuit par un laser ou des lampes pour effectuer un chauffage superficiel de la couche de silicium germanium.

Selon un mode de réalisation, le recuit comprend un premier recuit à une température comprise entre 300 et 500°C suivi par un deuxième recuit à une température supérieure à 500°C.

Selon un mode de réalisation, le procédé comprend en outre, après l'étape de recuit, une gravure pour enlever au moins partiellement la couche de silicium germanium.

Selon un mode de réalisation, le procédé comprend en outre la croissance, par épitaxie, d'une couche supplémentaire sur la couche de silicium germanium.

Selon un mode de réalisation, les atomes implantés sont des atomes d'argon.

Selon un autre aspect, il est prévu un dispositif comprenant une couche de silicium contrainte disposée sur un substrat, dans lequel la couche de silicium contrainte a un niveau de contrainte de compression ou de traction d'au moins 800 MPa et une densité maximale de dislocations de 10⁴/cm².

Selon un mode de réalisation, le dispositif comprend une couche de silicium germanium disposée sur une partie de la couche de silicium contrainte.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A à 1C sont des vues en coupe d'une structure illustrant des étapes d'un procédé qui a été proposé pour former une couche de silicium contraint ;
les figures 2A à 2E sont des vues en coupe d'une structure illustrant des étapes d'un procédé de formation d'une couche de silicium contraint selon un exemple de réalisation de la présente description ; et
la figure 3 représente une structure selon un exemple de réalisation de la présente description.

Comme cela est usuel dans la représentation des structures à base de silicium, les diverses vues en coupe ne sont pas tracées à l'échelle. En outre, dans la description ci-après, des termes qui dépendent de l'orientation de la structure, tels que inférieur, supérieur, haut et bas, s'appliquent en considérant que la structure est orientée de la façon illustrée dans les figures.

### Description détaillée

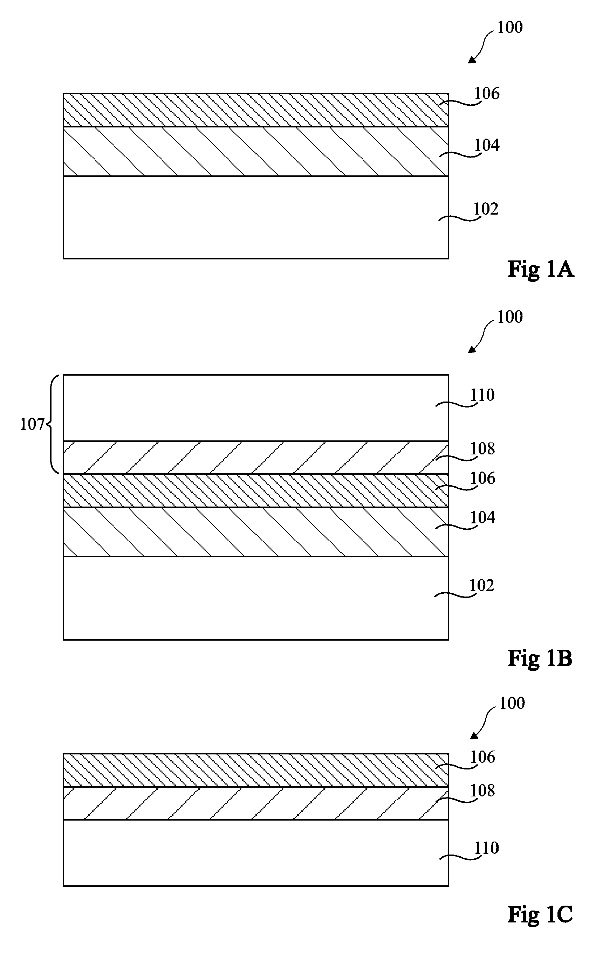

Les figures 1A à 1C sont des vues en coupe d'une structure à des étapes successives d'un procédé qui a été proposé pour former une couche de silicium contraint.
La figure 1A représente une structure 100 comprenant un substrat de silicium 102. Une couche de silicium germanium (SiGe) relaxée 104 a été formée par croissance épitaxiale sur le substrat de silicium 102. La couche de SiGe 104 comprend par exemple de plus faibles concentrations de germanium près de l'interface avec le substrat de silicium 102 et de plus fortes concentrations de germanium vers sa face supérieure. Une couche de silicium 106 a été formée par croissance épitaxiale au-dessus de la couche de SiGe 104, d'où il résulte une couche de silicium contraint étant donné que les atomes de silicium sont étirés au-delà de leur distance interatomique normale du fait de la présence de la couche de SiGe sous-jacente 104.
La figure 1B représente la structure 100 après une étape ultérieure dans laquelle un substrat support de silicium oxydé 107, comprenant une couche d'oxyde de silicium 108 et un substrat de silicium 110, est lié à la couche de silicium contraint 106.

La figure 1C représente la structure 100 après une étape ultérieure dans laquelle un meulage ou une séparation est réalisé pour enlever le substrat de silicium 102, et une étape de polissage mécano-chimique (CMP) et/ou une gravure sélective de SiGe est réalisée pour enlever la couche de SiGe 104. Il en résulte une structure de type SOI (Silicium sur Isolant) comprenant la couche de silicium contraint 106 liée au substrat support 110 par la couche d'oxyde 108.

Un inconvénient du processus des figures 1A à 1C est qu'une relativement forte densité de défauts peut être observée dans la couche de SiGe 104. En fait, même si la concentration de germanium de la couche de SiGe 104 est progressivement augmentée de 0 à une valeur typiquement comprise entre 10% et 50% à partir de l'interface avec le substrat 102 jusqu'à la surface de la couche de SiGe, la densité de dislocations reste à un niveau d'environ 10⁵/cm² dans la partie supérieure de la couche de SiGe 104. Ces défauts se transfèrent dans la couche de silicium épitaxiale 106. En outre, on observe souvent des irrégularités en forme de rayures croisées à la surface de la couche de SiGe 104 qui doit être enlevée en utilisant une étape de polissage mécano-chimique (chemical Mechanical Polishing ou CMP) avant de former la couche de silicium 106.

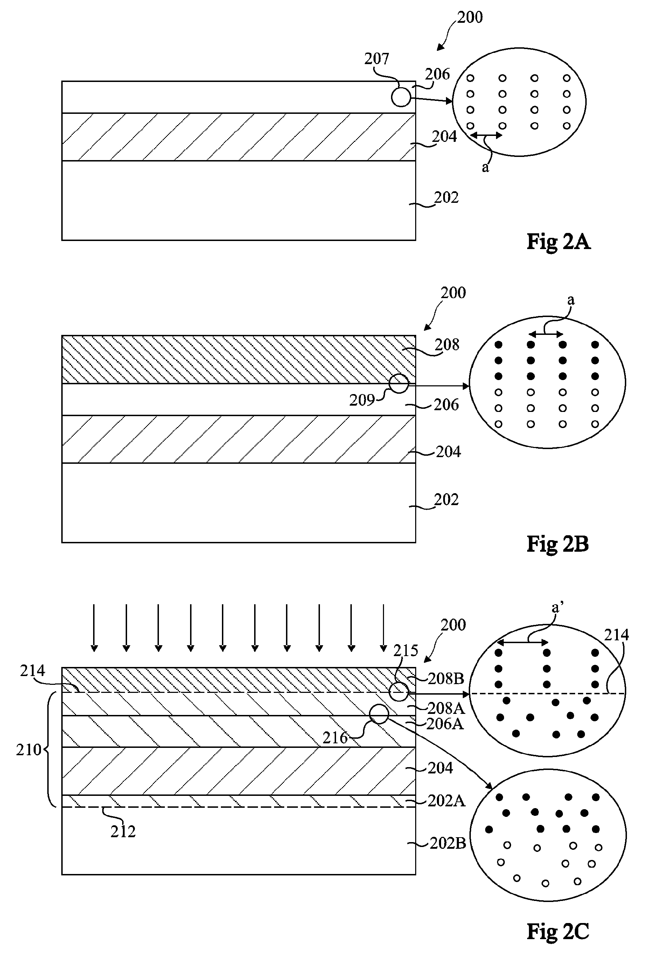

Les figures 2A à 2E sont des vues en coupe illustrant une structure 200 pendant des étapes successives d'un procédé de formation d'une couche de silicium contraint selon un exemple de réalisation.

La figure 2A est une première vue de la structure 200 qui est par exemple une structure sur isolant (SOI) comprenant un substrat de silicium 202 portant une couche d'isolant 204, par exemple du SiO₂, et une couche de silicium 206 formée au-dessus de la couche d'oxyde 204. L'épaisseur de la couche 206 est par exemple dans une plage de 4 à 60 nm, et typiquement dans une plage de 5 à 20 nm, par exemple d'environ 10 nm. L'épaisseur de la couche d'oxyde 204 est typiquement comprise entre 10 et 200 nm, par exemple de 145 nm.

Pour aider à comprendre les structures atomiques des diverses couches de silicium et de SiGe, l'agencement des atomes a été représenté très schématiquement en figures 2A à 2E. Bien sûr, de telles représentations simplistes n'ont pas pour but d'illustrer avec une précision quelconque la disposition réelle des atomes dans la structure. En figure 2A, une zone 207 de la couche de silicium 206 est représentée comme ayant une structure monocristalline uniforme avec des atomes régulièrement espacés d'une distance interatomique a.

La figure 2B illustre la structure 200 après une étape ultérieure dans laquelle une couche contrainte de SiGe 208 est formée, par croissance épitaxiale, au-dessus de la couche de silicium 206. L'épaisseur de la couche de SiGe est par exemple choisie pour être inférieure à l'épaisseur critique de relaxation telle qu'exposée en détail par exemple dans la publication intitulée "Critical thickness for plastic relaxation of SiGe on Si(001) revisited", J.M. Hartmann et al., Journal of Applied Physics 110, 083529 (2011), et dans la publication intitulée "Strain relaxation kinetics in Si1-xGex/Si heterostructures", D.C. Houghton, Journal of Applied Physics 70, 2136(1991). Pour une concentration de Ge de 20 %, l'épaisseur de la couche de SiGe est par exemple de l'ordre de 50 nm. Plus généralement, l'épaisseur de la couche de SiGe est par exemple dans une plage de 20 à 200 nm, fonction des proportions respectives de germanium et de silicium. Rester sous l'épaisseur critique conduit à une bonne qualité de la couche de SiGe épitaxiée. En particulier, la couche de SiGe a plus de chance de croître sans défaut avec le paramètre de maille de la couche sous-jacente, ici de silicium.

La concentration de germanium est par exemple dans une plage de 10 à 50 %, par exemple environ 20 %. La couche 208 est pseudomorphe, ce qui signifie que la distance interatomique à l'interface avec la couche sous-jacente de silicium 206 correspond à celle des atomes de silicium de la couche 206. En fait, la structure cristalline au niveau d'une zone 209 à l'interface entre la couche de silicium 206 et la couche de SiGe 208 est représentée en figure 2B, les atomes de SiGe étant représentés par des points et les atomes de silicium par des ronds. Comme cela est représenté, près de l'interface avec la couche de silicium 206, la distance interatomique dans la couche de SiGe est égale à a, identique à celle des atomes de silicium de la couche 206. Si on reste sous l'épaisseur critique, cette distance interatomique est conservée sur toute l'épaisseur de la couche de SiGe épitaxiée.

La figure 2C représente la structure 200 à une étape ultérieure dans laquelle des atomes sont implantés pour amorphiser la couche de silicium 206 et également une partie inférieure 208A de la couche de SiGe 208. Une partie superficielle 208B de la couche SiGe n'est pas amorphisée et reste donc cristalline. La partie superficielle 208B a par exemple une épaisseur d'au moins 1 nm. Du fait de l'amorphisation des couches sous-jacentes, cette partie superficielle se relaxe d'un certain niveau pour retourner partiellement à son paramètre de maille naturel. On retrouve ainsi dans cette couche relaxée une distance interatomique a' différente de la distance interatomique a dans le silicium relaxé.

Dans l'exemple de la figure 2C, une zone désignée par la référence 210 est amorphisée par l'implantation. La zone 210 s'étend vers le bas sur une profondeur indiquée par le trait en pointillés 212, qui se trouve dans le substrat de silicium 202. Ainsi, une partie supérieure 202A du substrat de silicium 202 est également amorphisée. Dans des variantes de réalisation, la limite 212 de l'implantation pourrait tomber dans la couche d'oxyde 204, c'est à dire que l'épaisseur de la couche amorphisée 202A serait nulle, i.e. il n'y aurait pas d'amorphisation du substrat 202.

La limite supérieure de la zone 210 est représentée par un trait en pointillés 214. La structure cristalline dans une zone 215 au niveau de la limite supérieure 210 est représentée en figure 2C et montre qu'au-dessus de cette limite la couche de SiGe a par exemple une structure cristalline avec une distance interatomique égale à a' correspondant à l'état relaxé du SiGe. Au-dessous de cette limite 210, les atomes sont répartis irrégulièrement, en raison de l'état amorphe.

La structure atomique dans une zone 216 à l'interface de la couche de SiGe amorphe 208A et de la couche de silicium amorphe 206A est également représentée en figure 2C et indique que, au niveau de cette interface, les atomes de SiGe supérieurs et les atomes de silicium sous-jacents sont par exemple répartis de façon aléatoire en raison de l'état amorphisé.

L'amorphisation est, par exemple, réalisée par implantation ionique d'argon à une énergie choisie en fonction des épaisseurs de la couche de silicium 206 et de la couche de SiGe 208. La détermination de cette énergie peut être obtenue par des méthodes de calcul connues par l'homme de l'art. On pourra notamment utiliser le logiciel SRIM (en anglais "Stopping and Range of Ions in Matter"), couramment utilisé dans le domaine de l'implantation pour définir des profils d'implantation. Pour une épaisseur de silicium 206 de 8 nm et de SiGe de 50 nm, l'énergie d'implantation est par exemple de 150 keV, et la dose d'implantation est par exemple comprise entre 1x10¹⁴ et 2x10¹⁴ atomes/cm².

Dans des variantes de réalisation, d'autres types d'atomes ou plus généralement de particules pourraient être utilisés pour amorphiser les couches de silicium et de SiGe 206A, 208A, l'énergie et la dose dépendant notamment de l'épaisseur des couches et du type de particules implantées.

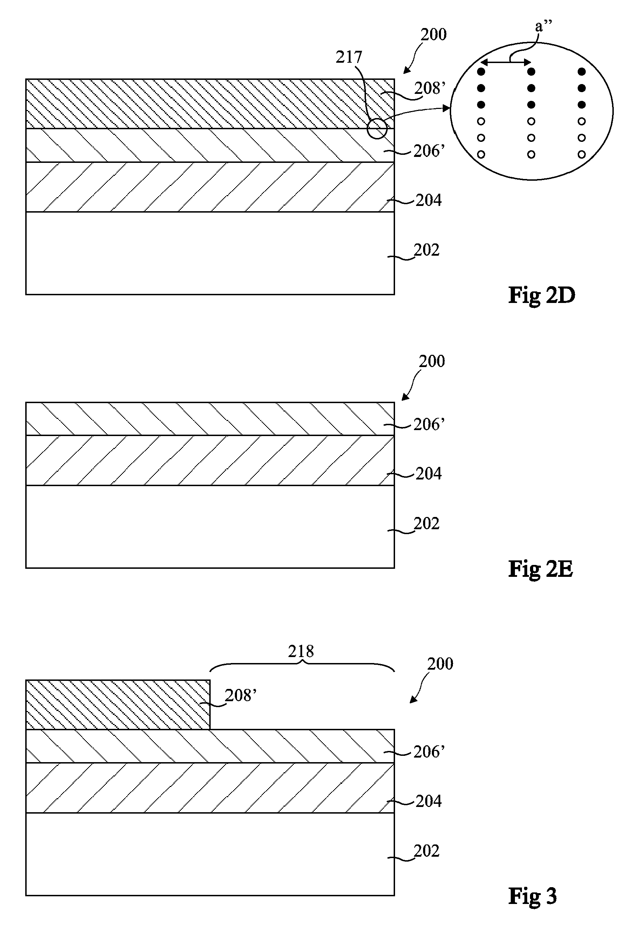

La figure 2D illustre la structure après une étape subséquente de recuit pour relaxer encore la partie superficielle 208B de la couche de SiGe, puis recristalliser la partie inférieure amorphe 208A de la couche de SiGe et la couche de silicium amorphe 206A. En d'autres termes, le recuit correspond à une épitaxie en phase solide (SPE). La partie superficielle 208B de la couche de SiGe agit comme couche germe. Pour assurer cette recristallisation à partir de la couche germe 208B de SiGe relaxée sur l'ensemble de la couche de silicium 206A, la couche de silicium 206A est par exemple avantageusement cristallographiquement indépendante de la couche sur laquelle elle repose. C'est le cas notamment si la couche sous-jacente est une couche amorphe, telle que l'oxyde 204, bien que d'autres types de couche amorphe pourraient être utilisés.

Le recuit est par exemple réalisé entre environ 500 et 1100°C, et de préférence entre 500 et 700°C, par exemple à environ 550°C. Afin de favoriser la relaxation de la partie superficielle 208B de la couche de SiGe avant la recristallisation, selon un mode de réalisation, le recuit est un recuit de surface réalisé par un laser ou des lampes, telles que des lampes à flash, permettant un chauffage superficiel de la couche de SiGe.

A titre de variante, ou en plus, l'étape de recuit comprend un premier recuit à une température relativement basse, par exemple comprise entre 300 et 500°C, suivi par un deuxième recuit à une température plus élevée et supérieure à 500°C, et par exemple dans la plage de 500 à 1100°C. Le premier recuit a par exemple une durée comprise entre 30 secondes et plusieurs heures, et a pour résultat le fluage au moins partiel de la couche d'isolant 204, ce qui favorise la relaxation de la partie superficielle 208B de la couche de SiGe. Le premier recuit est par exemple réalisé à une température comprise entre 400 et 500°C pendant une durée comprise entre 30 secondes et 5 minutes, ou à une température comprise entre 300°C et 400°C pendant une durée comprise entre 5 minutes et plusieurs heures. Le deuxième recuit a par exemple une durée comprise entre 30 secondes et 10 minutes, et a pour résultat la recristallisation de la couche de SiGe amorphe 208A et de la couche de silicium amorphe 206A.

Le résultat des étapes de recuit et de recristallisation est que la couche de SiGe 208 devient une couche relaxée 208' dans laquelle la distance interatomique a" correspond à celle du SiGe relaxé, et que la couche de silicium 206' devient une couche contrainte 206' ayant la même distance interatomique que la couche SiGe 208'. La structure atomique dans une zone 217 à l'interface entre la couche de SiGe 208' et la couche de silicium 206' est représentée en figure 2D, et indique que les atomes de SiGe et les atomes de silicium ont tout deux des distances interatomiques a" correspondant à celle de la couche de SiGe 208 à l'état relaxé.

Par exemple, la couche de silicium contrainte 206' obtenue a un niveau de contrainte de compression ou de traction d'au moins 800 MPa et une densité maximale de dislocations de 10⁴/cm².

En outre, en dépit de l'amorphisation de la partie supérieure 202A de la couche de silicium 202 (voir figure 2C), l'étape de recuit recristallise également cette partie. Ainsi, même si l'étape d'implantation déborde de la couche d'oxyde 204, le substrat de silicium 202 revient à une structure cristalline.

La structure 200 de la figure 2D, avec la couche 208' de SiGe relaxée, peut être utilisée comme substrat pour la croissance, par épitaxie, d'une couche supplémentaire de silicium contraint ou tout autre matériau présentant un accord de maille avec SiGe.

A titre de variantes, d'autres étapes de traitement peuvent être réalisées comme cela va être maintenant décrit en relation avec les figures 2E et 3.

La figure 2E représente la structure 200 après une étape ultérieure dans laquelle la couche de SiGe 208' est enlevée par exemple par CMP et/ou gravure du SiGe. Le résultat en est une structure SOI comprenant la couche de silicium contraint 206' au-dessus de la couche d'oxyde 204 et du substrat de silicium 202.

La figure 3 est une vue en coupe de la structure 200 après une étape qui constitue une variante de celle de la figure 2E. En particulier, plutôt que d'enlever toute la couche de SiGe 208', celle-ci est seulement partiellement enlevée par gravure du SiGe dans une région 218 pour exposer la couche de silicium contraint sous-jacente 206'.

Dans la structure 200 de la figure 3, des transistors MOS à canal P à haute performance sont par exemple formés dans la partie restante de la couche de SiGe 208', tandis que des transistors MOS à canal N à haute performance sont par exemple formés dans la couche de silicium contraint 206'.

Dans des modes de réalisation, pendant l'étape d'implantation, un masque est employé pour localiser l'implantation dans les couches 206, 208 de Si et de SiGe. La couche de Si 206 peut donc être contrainte dans certaines régions et non contrainte dans d'autres régions.

Un avantage des modes de réalisation décrits ici est qu'une couche de silicium contraint peut être formée sans utiliser de croissance épitaxiale au-dessus d'une couche de SiGe. Au lieu de cela, la couche de silicium est contrainte par une étape de recristallisation basée sur une couche germe de SiGe, d'où il résulte une couche de silicium contraint de particulièrement bonne qualité avec une très faible densité de défauts. En outre, le processus est particulièrement simple et peu coûteux et n'implique pas d'étape de collage moléculaire après la formation de la couche de silicium contraint.

De façon avantageuse, la couche de SiGe est initialement contrainte, et est ensuite relaxée par les étapes d'implantation et de recuit. Cela conduit à des couches de SiGe et de Si cristallisées ayant peu de défauts.

Bien que l'on ait décrit ici un mode de réalisation préféré, diverses modifications, variantes et améliorations apparaîtront à l'homme de l'art.

Par exemple il sera clair pour l'homme de l'art que bien que l'on ait décrit un exemple de réalisation dans lequel le procédé part d'une structure SOI avec une couche d'oxyde 204 formée sur un substrat de silicium 202, le procédé pourrait s'appliquer à des couches de silicium formées sur d'autres isolants et substrats.

## Revendications

1. Procédé comprenant :
formation d'une couche contrainte de silicium germanium (208) par croissance épitaxiale sur une couche de silicium (206) disposée sur un substrat (202) ;
implantation des atomes pour amorphiser la couche de silicium et une partie inférieure (208A) de la couche de silicium germanium sans amorphiser une partie superficielle (208B) de la couche de silicium germanium ; et
recuit pour au moins partiellement relaxer la couche de silicium germanium et pour recristalliser la partie inférieure (208A) de la couche de silicium germanium et la couche de silicium (206), d'où il résulte que la couche de silicium devient une couche de silicium contraint (206').

2. Procédé selon la revendication 1, dans lequel la couche de silicium (206) est formée sur une couche amorphe (204) disposée sur le substrat (202).

3. Procédé selon la revendication 2, dans lequel, pendant l'étape d'implantation, des atomes sont implantés à profondeur maximum tombant dans la couche amorphe ou dans le substrat (202).

4. Procédé selon la revendication 1, dans lequel l'implantation des atomes pendant l'étape d'implantation est localisée par un masque.

5. Procédé selon l'une quelconque des revendications 1 à 4, dans lequel la couche de silicium germanium (208) a une épaisseur comprise entre 20 et 200 nm.

6. Procédé selon la revendication 5, dans lequel la couche de silicium germanium (208) a une épaisseur inférieure à l'épaisseur critique, épaisseur sous laquelle le SiGe croît sans défaut avec le paramètre de maille de la couche de silicium sous-jacente.

7. Procédé selon l'une quelconque des revendications 1 à 6, dans lequel la couche de silicium germanium (208) a une concentration en germanium comprise entre 10 et 50 %.

8. Procédé selon l'une quelconque des revendications 1 à 7, dans lequel la partie superficielle (208B) a une épaisseur d'au moins 1 nm.

9. Procédé selon l'une quelconque des revendications 1 à 8, dans lequel le recuit est réalisé à une température comprise entre 500°C et 1100°C.

10. Procédé selon l'une quelconque des revendications 1 à 9, dans lequel le recuit comprend un premier recuit à une température comprise entre 300 et 500°C suivi par un deuxième recuit à une température supérieure à 500°C.

11. Procédé selon l'une quelconque des revendications 1 à 10, dans lequel le recuit comprend un recuit par un laser ou des lampes pour effectuer un chauffage superficiel de la couche de silicium germanium (208).

12. Procédé selon l'une quelconque des revendications 1 à 11 comprenant en outre, après l'étape de recuit, une gravure pour enlever au moins partiellement la couche de silicium germanium (208').

13. Procédé selon l'une quelconque de revendications 1 à 12, comprenant en outre la croissance, par épitaxie, d'une couche supplémentaire sur la couche de silicium germanium (208').

14. Dispositif comprenant une couche de silicium contrainte (206') disposée sur un substrat (202), dans lequel la couche de silicium contrainte a un niveau de contrainte de compression ou de traction d'au moins 800 MPa et une densité maximale de dislocations de 10⁴/cm².

15. Dispositif selon la revendication 14, comprenant une couche de silicium germanium disposée sur une partie de la couche de silicium contrainte (206').
